(19) **Europäisches Patentamt**
**European Patent Office**
**Office européen des brevets**

(11) **EP 4 583 366 A1**

(12) **EUROPEAN PATENT APPLICATION**
published in accordance with Art. 153(4) EPC

(43) Date of publication:
09.07.2025 Bulletin 2025/28

(21) Application number: 23875122.6

(22) Date of filing: 20.09.2023

(51) International Patent Classification (IPC):
H02J 50/90 (2016.01)     H02J 50/12 (2016.01)
H02J 50/00 (2016.01)     H01Q 1/38 (2006.01)
H01Q 7/06 (2006.01)     H01Q 1/24 (2006.01)
G01K 1/02 (2021.01)     H01F 27/40 (2006.01)

(52) Cooperative Patent Classification (CPC):
G01K 1/02; H01F 27/40; H01Q 1/24; H01Q 1/38;
H01Q 7/06; H02J 50/00; H02J 50/12; H02J 50/90

(86) International application number:
PCT/KR2023/014319

(87) International publication number:
WO 2024/076055 (11.04.2024 Gazette 2024/15)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 06.10.2022 KR 20220128203
10.11.2022 KR 20220149696

(71) Applicant: Samsung Electronics Co., Ltd.
Suwon-si, Gyeonggi-do 16677 (KR)

(72) Inventors:
• LIM, Taejun
Suwon-si, Gyeonggi-do 16677 (KR)
• PARK, Jungsik
Suwon-si, Gyeonggi-do 16677 (KR)
• LEE, Woosup
Suwon-si, Gyeonggi-do 16677 (KR)

(74) Representative: Appleyard Lees IP LLP
15 Clare Road
Halifax HX1 2HY (GB)

(54) **ELECTRONIC APPARATUS INCLUDING PLURALITY OF COILS**

(57) An electronic apparatus according to an embodiment comprises: a battery; a first coil arranged on the battery; a second coil magnetically coupled to the first coil and wound along an edge of the first coil; a variable capacitor connected to the first coil; and a control circuit connected to the second coil and configured to supply a current to the second coil to generate an induced current in the first coil, supply power from an external electronic apparatus to the battery or transmit power from the battery to the external electronic apparatus on the basis of the current and the induced current, wherein a capacitance value of the variable capacitor may be changed on the basis of the identified location of the external electronic apparatus. Other embodiments are also possible.

FIG. 4

**Description**

**[Technical Field]**

Various embodiments of the present disclosure relate to an electronic device including a plurality of coils.

**[Background Art]**

An electronic device may include an antenna for wireless communication for interaction with an external electronic device. The antenna for the wireless communication may include a wireless charging antenna, an antenna for magnetic safety transmission, a short-range communication antenna, or a long-distance communication antenna.
A communication performance of the antenna for the wireless communication may vary according to a position or a direction of the external electronic device communicating with the electronic device.

**[Disclosure]**

**[Technical Solution]**

According to an embodiment, an electronic device may comprise a battery, a first coil and a second coil disposed on the battery. According to an embodiment, the second coil may be magnetically coupled with the first coil, and wound along a periphery of the first coil. The electronic device may comprise a variable capacitor, control circuitry, a sensor, and a processor. The variable capacitor may be connected with the first coil. The control circuitry, connected with the second coil, may be configured to supply a current to the second coil to generate an induced current in the first coil, and based on the current and the induced current, supply power from an external electronic device to the battery or transmit power from the battery to the external electronic device. The sensor may be configured to identify a position of the external electronic device with respect to the first coil or the second coil. The processor may be configured to identify, via the sensor, the position of the external electronic device with respect to the first coil or the second coil. The processor may be configured to, based on the identified position of the external electronic device, change a capacitance value of the variable capacitor.
According to an embodiment, an electronic device may comprise a battery, a first coil and a second coil disposed on the battery. The second coil may be magnetically coupled with the first coil, and wound along a periphery of the first coil. The electronic device may comprise control circuitry, a variable capacitor, a sensor, and a processor. The control circuitry, connected with the first coil, may be configured to supply a current to the first coil to generate an induced current in the second coil, and based on the current and the induced current, supply power from an external electronic device to the battery or transmit power from the battery to the external electronic device. The variable capacitor may be connected with the second coil. The sensor may be configured to identify a position of the external electronic device with respect to the first coil or the second coil. The processor may be configured to identify, via the sensor, the position of the external electronic device with respect to the first coil or the second coil. The processor may be configured to, based on the identified position of the external electronic device, change a capacitance value of the variable capacitor.

**[Description of the Drawings]**

FIG. 1 is a block diagram of an electronic device in a network environment according to various embodiments.
FIG. 2 is a block diagram for a wireless communication module, a power management module, and an antenna module of an electronic device according to various embodiments.
FIG. 3 is a top plan view exemplarily illustrating an internal configuration of an electronic device with a rear plate removed, according to an embodiment.
FIG. 4 is a diagram exemplarily illustrating a disposition of a first coil and a second coil of an electronic device according to an embodiment.
FIGS. 5A and 5B are circuitry diagrams illustrating exemplary equivalent circuitry of a first coil and a second coil of an electronic device according to an embodiment.
FIGS. 6A and 6B are cross-sectional views of an exemplary antenna including a first coil and a second coil of an electronic device according to an embodiment.
FIG. 7 is a diagram exemplarily illustrating a disposition of an electronic device and a wireless charger, according to an embodiment.
FIG. 8 is a diagram exemplarily illustrating a disposition of an electronic device and a watch, according to an embodiment.

FIGS. 9A and 9B illustrate inductance and a resistance value of a coil according to capacitance of a capacitor according to an embodiment.

**[Mode for Invention]**

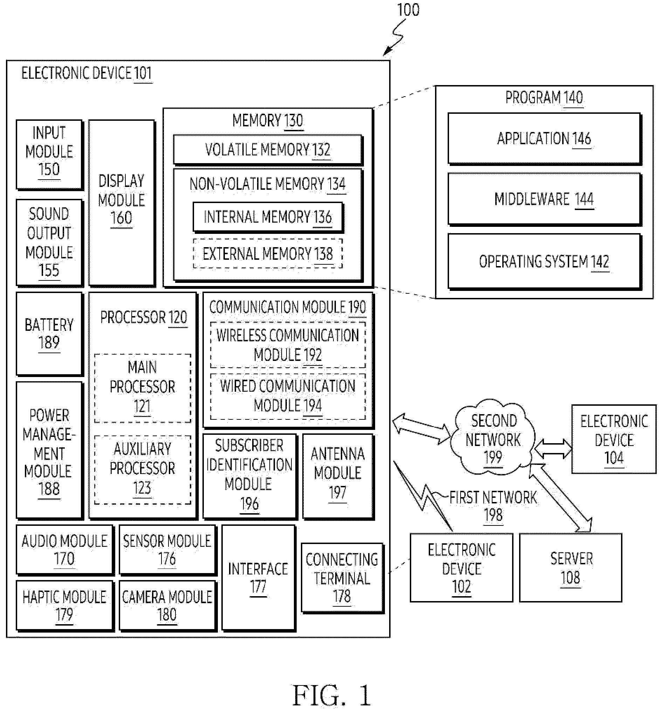

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

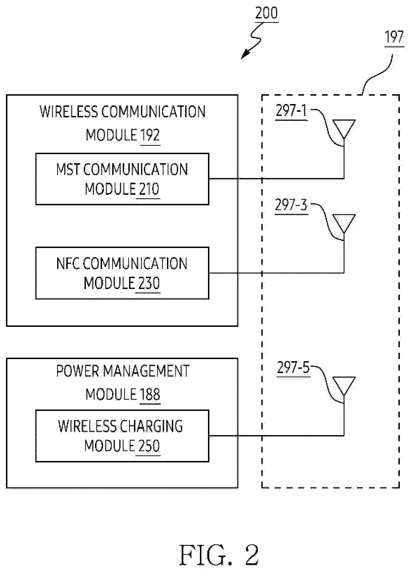

FIG. 2 is a block diagram 200 illustrating the wireless communication module 192, the power management module 188, and the antenna module 197 of the electronic device 101 according to various embodiments.

Referring to FIG. 2, the wireless communication module 192 may include a magnetic secure transmission (MST) communication module 210 or a near-field communication (NFC) module 230, and the power management module 188 may include a wireless charging module 250. In such a case, the antenna module 197 may include a plurality of antennas that include a MST antenna 297-1 connected with the MST communication module 210, a NFC antenna 297-3 connected with the NFC communication module 230, and a wireless charging antenna 297-5 connected with the wireless charging module 250. For ease of description, the same components as those described in regard to FIG. 1 are briefly described or omitted from the description.

The MST communication module 210 may receive a signal containing control information or payment information such as card information from the processor 120, generate a magnetic signal corresponding to the received signal, and then transfer the generated magnetic signal to the external electronic device 102 (e.g., a point-of-sale (POS) device) via the MST antenna 297-1. To generate the magnetic signal, according to an embodiment, the MST communication module 210 may include a switching module (not shown) that includes one or more switches connected with the MST antenna 297-1, and control the switching module to change the direction of voltage or current supplied to the MST antenna 297-1 according to the received signal. The change of the direction of the voltage or current allows the direction of the magnetic signal (e.g., a magnetic field) emitted from the MST antenna 297-1 to change accordingly. If detected at the external electronic device 102, the magnetic signal with its direction changing may cause an effect (e.g., a waveform) similar to that of a magnetic field that is generated when a magnetic card corresponding to the card information associated with the received signal is swiped through a card reader of the electronic device 102. According to an embodiment, for example, payment-related information and a control signal that are received by the electronic device 102 in the form of the magnetic signal may be further transmitted to an external server 108 (e.g., a payment server) via the network 199.

The NFC communication module 230 may obtain a signal containing control information or payment information such as card information from the processor 120 and transmit the obtained signal to the external electronic device 102 via the NFC antenna 297-3. According to an embodiment, the NFC communication module 230 may receive such a signal transmitted from the external electronic device 102 via the NFC antenna 297-3.

The wireless charging module 250 may wirelessly transmit power to the external electronic device 102 (e.g., a cellular phone or wearable device) via the wireless charging antenna 297-5, or wirelessly receive power from the external electronic device 102 (e.g., a wireless charging device). The wireless charging module 250 may support one or more of various wireless charging schemes including, for example, a magnetic resonance scheme or a magnetic induction scheme.

According to an embodiment, some of the MST antenna 297-1, the NFC antenna 297-3, or the wireless charging antenna 297-5 may share at least part of their radiators. For example, the radiator of the MST antenna 297-1 may be used as the radiator of the NFC antenna 297-3 or the wireless charging antenna 297-5, or vice versa. In such a case, the antenna module 197 may include a switching circuit (not shown) adapted to selectively connect (e.g., close) or disconnect (e.g., open) at least part of the antennas 297-1, 297-3, or 297-5, for example, under the control of the wireless communication module 192 (e.g., the MST communication module 210 or the NFC communication module 230) or the power management module (e.g., the wireless charging module 250). For example, when the electronic device 101 uses a wireless charging function, the NFC communication module 230 or the wireless charging module 250 may control the switching circuit to temporarily disconnect at least one portion of the radiators shared by the NFC antenna 297-3 and the wireless charging antenna 297-5 from the NFC antenna 297-3 and to connect the at least one portion of the radiators with the wireless charging antenna 297-5.

According to an embodiment, at least one function of the MST communication module 210, the NFC communication module 230, or the wireless charging module 250 may be controlled by an external processor (e.g., the processor 120). According to an embodiment, at least one specified function (e.g., a payment function) of the MST communication module 210 or the NFC communication module 230 may be performed in a trusted execution environment (TEE). According to an embodiment, the TEE may form an execution environment in which, for example, at least some designated area of the memory 130 is allocated to be used for performing a function (e.g., a financial transaction or personal information-related function) that requires a relatively high level of security. In such a case, access to the at least some designated area of the memory 130 may be restrictively permitted, for example, according to an entity accessing thereto or an application being executed in the TEE.

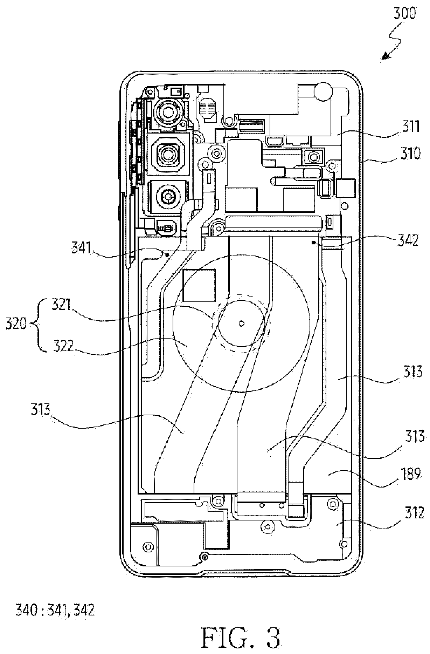

FIG. 3 is a top plan view exemplarily illustrating an internal configuration of an electronic device with a rear plate removed, according to an embodiment.

Referring to FIG. 3, an electronic device 300 may include a housing 310 and a first printed circuit board 311.

According to an embodiment, the electronic device 300 may be a portable electronic device capable of transmitting and receiving a signal or power with an external electronic device. For example, the electronic device 300 may perform data communication with the external electronic device, and transmit power to the external electronic device or receive power from the external electronic device. For example, by receiving power from the external electronic device, the electronic device 300 may be supplied with power for driving the electronic device 300. By transmitting power to the external electronic device, the electronic device 300 may supply power for driving the external electronic device.

According to an embodiment, the housing 310 may form an internal space of the electronic device 300. The housing 310 may form at least a portion of an exterior of the electronic device 300. The internal space may be a space for disposing a component for driving the electronic device 300. For example, the electronic device 300 may include the first printed circuit board 311, a second printed circuit board 312, a power management module 188 (e.g., the power management module 188 of FIG. 1), a wireless communication module 192 (e.g., the wireless communication module 192 of FIG. 1), and/or a battery 189 disposed in the internal space.

According to an embodiment, the first printed circuit board 311 may include a processor (e.g., the processor 120 of FIG. 1) configured to control components inside the electronic device 300. The electronic device 300 may include the second printed circuit board 312 distinguished from the first printed circuit board 311. The first printed circuit board 311 and the second printed circuit board 312 may be electrically connected via at least one flexible printed circuit board 313. The first printed circuit board 311 may be disposed at an end of the housing 310, and the second printed circuit board 312 may be disposed at another end of the housing 310. The end and the other end of the housing 310 may mean a short periphery in contact with long peripheries of the housing 310. The first printed circuit board 311 may be referred to as a main printed circuit board in terms of including the processor 120 disposed in the first printed circuit board 311 and controlling the components of the electronic device 300. The second printed circuit board 312 may assist the first printed circuit board 311 and be electrically connected to an interface or a speaker disposed in the second printed circuit board 312. The second printed circuit board 312 may be referred to as an auxiliary printed circuit board in terms of assisting the first printed circuit board 311.

The electronic device 300 according to an embodiment may include a coil module 320 connected to control circuitry (e.g., the power management module 188 or the wireless communication module 192). The coil module 320 may be disposed between a rear plate and the battery 189. The coil module 320 may be referred to as an antenna module in terms of transmitting and receiving a signal or power with the external electronic device. The coil module 320 may include a first coil 321 and a second coil 322. The coil module 320 including the first coil 321 and the second coil 322 may include, for example, a near field communication (NFC) antenna, a wireless charging antenna, and/or a magnetic secure transmission (MST) antenna. The coil module 320 may, for example, perform short-range communication with the external device, or wirelessly transmit and receive power with the external device. A non-conductive plate (not shown) may cover the first coil 321 and the second coil 322 along a periphery of the housing 310. By disposing the non-conductive plate, a signal or power transmitted via the first coil 321 and the second coil 322 may pass via the non-conductive plate and be transmitted to the external electronic device. However, it is not limited thereto, and a portion including the first coil 321 and the second coil 322 of a plate forming a rear surface of the electronic device may include a non-conductive material, and another portion may include a conductive material. The plate forming the rear surface may be formed via a double injection process.

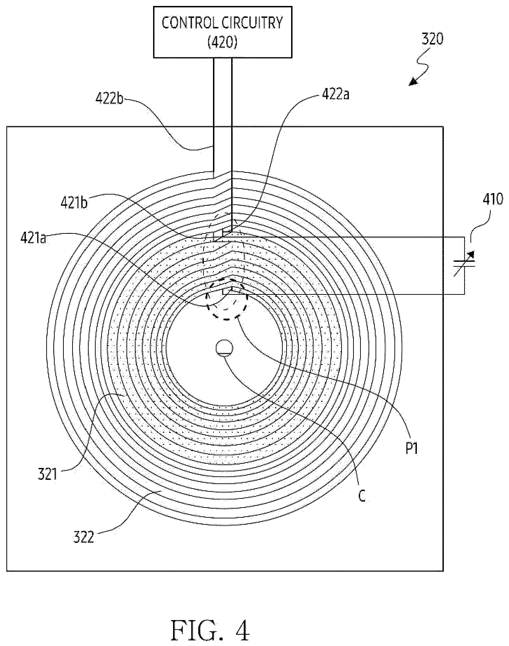

According to an embodiment, the electronic device 300 may include a sensor 340. According to an embodiment, the sensor 340 may be configured to increase accuracy of identifying a position of the external electronic device. For example, the sensor 340 may include a plurality of sensors 341 and 342. The first sensor 341 may be biased to a side (e.g., a left side) centered on the first coil 321 and the second coil 322. The second sensor 342 may be biased to another side (e.g., a right side) centered on the first coil 321 and the second coil 322. The sensor 340 may be configured to identify the position of the external electronic device with respect to the first coil 321 or the second coil 322. The sensor 340 may obtain data related to access of the external electronic device or the position of the external electronic device. The processor (e.g., the processor 120 of FIG. 1) may obtain a sensing value via the sensor 340. The processor may identify an alignment distance from a center of the first coil 321 and the second coil 322 to a center of a charging coil of the external electronic device based on the sensing value. The processor may be configured to control magnitude of the induced current of the first coil and magnitude of the current of the second coil via the variable capacitor (e.g., a variable capacitor 410 of FIG. 4) based on the alignment distance.

According to an embodiment, the sensor 340 may include a temperature sensor. The sensor 340 may obtain a temperature around the first coil 321 and the second coil 322 according to communication (e.g., providing power to the external electronic device or supplying power from the external electronic device) with the external electronic device. The sensor 340 may obtain data related to heat generation of the first coil 321 and the second coil 322 generated based on interaction between the coil module 320 including the first coil 321 and the second coil 322 and an antenna module of the external electronic device. The processor 120 may identify the position of the external electronic device based on data related to the heat generation of the first coil 321 and the second coil 322 obtained via the sensor 340. For example, based on first sensing data obtained from the first sensor 341 and second sensing data obtained from the second sensor 322, the processor 120 may identify whether the external electronic device is aligned with respect to the center of the first coil 321 and the second coil 322. Based on a reference value of the first sensing data and a reference value of the second sensing data, the processor 120 may obtain a first difference between the first sensing data and the reference value of the first sensing data and a second difference between the second sensing data and the reference value of the second sensing data. For example, when a size of the first difference and a size of the second difference are within a designated range, the processor 120 may identify that the external electronic device is aligned with the first coil 321 and the second coil 322. When the first difference (e.g., a value of the first sensing data minus the reference value of the first sensing data) is a negative value and the second difference (e.g., a value of the second sensing data minus the reference value of the second sensing data) is a positive value, the processor 120 may identify that the external electronic device is biased to the second sensor 342 with respect to the center of the first coil 321 and the second coil 322.

According to an embodiment, the sensor 340 may include a Hall sensor. The Hall sensor may identify magnitude or a direction of a magnetic field caused by an electromagnetic wave generated by interaction between the antenna module of the external electronic device and the first coil 321 or the second coil 322 of the coil module 320 of the electronic device 300. The sensor 340 may obtain data related to a change in the magnetic field. The processor 120 may identify whether the external electronic device is aligned with the first coil and the second coil based on the data obtained via the sensor 340. However, it is not limited thereto and the sensor 340 may include a proximity sensor or a conductive pattern capable of identifying the position or the access of the external electronic device.

In an embodiment, the battery 189 may supply power to at least one component of the electronic device 300. For example, the battery 189 may include a rechargeable secondary battery or a fuel cell. At least a portion of the battery 189 may be disposed on substantially the same plane as the first printed circuit board 311 and/or the second printed circuit board 312. The battery 189 may be disposed under the coil module 320 including the first coil 321 and the second coil 322. For example, when the electronic device 300 is viewed from above, the battery 189 may overlap with the first coil 321 and the second coil 322.

According to an embodiment, the battery 189 may be supplied with power received from the external electronic device via the first coil 321 and the second coil 322, or may supply power to the external electronic device via the first coil 321 and the second coil 322.

The electronic device according to the above-described embodiment may receive power from the external electronic device (e.g., a wireless charger) by including the first coil 321 and the second coil 322. The electronic device 300 may share power in an emergency by supplying power to the external electronic device (e.g., a wirelessly chargeable electronic device) via the first coil 321 and the second coil 322.

FIG. 4 is a diagram exemplarily illustrating a disposition of a first coil and a second coil of an electronic device according to an embodiment.

Referring to FIG. 4, a coil module 320 may include a first coil 321, a second coil 322, a variable capacitor 410, and control circuitry 420.

According to an embodiment, the first coil 321 and the second coil 322 may be disposed on a battery (e.g., the battery 189 of FIG. 3). The first coil 321 may be referred to as an inner coil in terms of being disposed in an inner side of the second coil 322. The second coil 322 may be magnetically coupled to the first coil. The second coil 322 may be wound along a periphery of the first coil 321. The first coil 321 and the second coil 322 may have a donut shape having an inner circumference and an outer circumference. For example, the first coil 321 may be wound from an end 421a of the first coil 321 disposed at a position p1 spaced apart from a center c to another end 421b of the first coil 321 to move away from a center part. The second coil 322 may be wound from an end 422a of the second coil 322 disposed adjacent to a periphery of the first coil 321 to another end 422b of the second coil 322 to move away from the center part. The end 421a of the first coil 321, the other end 421b of the first coil 321, the end 422a of the second coil 322, and the other end 422b of the second coil 322 may be aligned with a line extending in a radial direction from the center c of the first coil 321 and the second coil 322. However, positions of the end 421a of the first coil 321, the other end 421b of the first coil 321, the end 422a of the second coil 322, and the other end 422b of the second coil 322 are not limited thereto. The positions of the end 421a of the first coil 321, the other end 421b of the first coil 321, the end 422a of the second coil 322, and the other end 422b of the second coil 322 may vary according to a position of a peripheral electronic component (e.g., the variable capacitor 410 or the control circuitry 420).

According to an embodiment, the variable capacitor 410 may be connected to the first coil 321. The end 421a of the first coil 321 and an end of the variable capacitor 410 may be connected, and the other end 421b of the first coil 321 and another end of the variable capacitor 410 may be connected. The variable capacitor 410 may change capacitance of the variable capacitor 410 connected in parallel with both ends of the first coil 321.

According to an embodiment, the control circuitry 420 may be connected to the second coil 322. The end 422a of the second coil 322 and an end of the control circuitry 420 may be connected, and the other end 422b of the second coil 322 and another end of the control circuitry 420 may be connected. The control circuitry 420 may manage power transmitted from the battery 189 to the coil module 320 including a power management module or a wireless charging module, or power transmitted from the coil module 320 to the battery 189. For example, the control circuitry 420 may be connected to the second coil 322, and configured to supply a current to the second coil 322 to generate an induced current in the first coil 321, and based on the current and the induced current, to supply power from an external electronic device to the battery 189 or to transmit power from the battery 189 to the external electronic device.

According to an embodiment, the control circuitry 420 or the processor 120 may change a capacitance value of a variable capacitor. Based on the change in the capacitance value of the variable capacitor, a current flowing in the first coil 321 and a current flowing in the second coil 322 may change.

According to the above-described embodiment, the processor 120 or the control circuitry 420 may control an amount of the current flowing in the first coil 321 or the second coil 322 via the variable capacitor 410. By controlling the amount of the current flowing in the first coil 321 or the second coil 322, the processor 120 may increase wireless charging efficiency with the external electronic device.

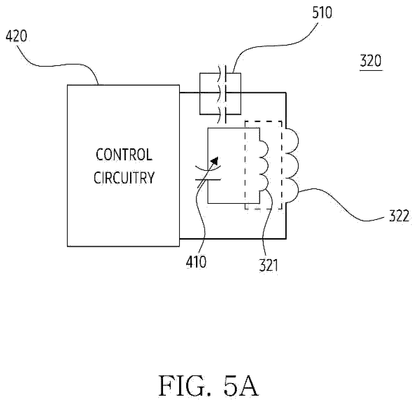

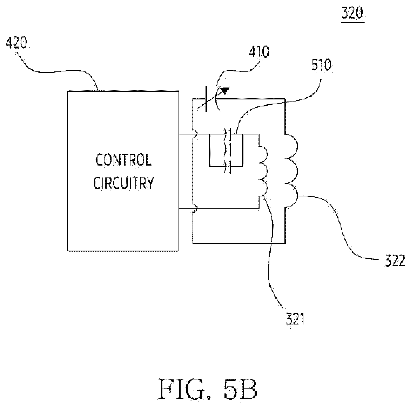

FIGS. 5A and 5B are circuitry diagrams illustrating exemplary equivalent circuitry of a first coil and a second coil of an electronic device according to an embodiment.

A coil module 320 may include a first coil 321, a second coil 322, a variable capacitor 410, and/or control circuitry 420. The first coil 321 may be magnetically coupled to the second coil 322. For example, based on a current flowing in the second coil 322, an induction current may flow in the first coil 321.

Referring to FIG. 5A, the first coil 321 may be connected to the variable capacitor 410. The second coil 322 may be connected to the control circuitry 420 and may be connected to a set 510 of capacitors. In the set 510 of the capacitors, a plurality of capacitors may be connected in parallel with each other.

Equivalent circuitry of FIG. 5A may be as shown in Equation 1 below.

【Equation 1】

$$\begin{pmatrix} Vs \\ 0 \end{pmatrix} = \begin{pmatrix} R_{out} + j\omega L_{out} + \dfrac{1}{j\omega C_{out}} & j\omega M \\ j\omega M & R_{in} + j\omega L_{in} + \dfrac{1}{j\omega C_{in}} \end{pmatrix} \begin{pmatrix} i_{out} \\ i_{in} \end{pmatrix}$$

$V\_s$ may be a voltage applied from the control circuitry to the second coil 322, $i\_out$ may be a current flowing in the second coil 322, and $i\_in$ may be a current flowing in the first coil 321. $R\_out$ may be an internal resistance of the second coil 322 and a conducting wire connected to the second coil 322, $L\_out$ may be inductance of the second coil 322, and $C\_out$ may be capacitance of an equivalent capacitor of the set 510 of the capacitors. $R\_in$ may be an internal resistance of the first coil 321 and a conducting wire connected to the first coil 321, $L\_in$ may be inductance of the first coil 321, and $C\_in$ may be capacitance of the variable capacitor 410.

【Equation 2】

$$\begin{pmatrix} Vs \\ 0 \end{pmatrix} = \begin{pmatrix} Z_{out} & j\omega M \\ j\omega M & Z_{in} \end{pmatrix} \begin{pmatrix} i_{out} \\ i_{in} \end{pmatrix}$$

When impedance of a loop including the first coil is represented as $Z\_in$ and impedance of a loop including the second coil is represented as $Z\_out$, the Equation 2 may be obtained from the Equation 1.

【Equation 3】

$$0 = j\omega M i_{out} + Z_{in} i_{in}$$

$$\therefore \ i_{out} : i_{in} = Z_{in} : -j\omega M$$

The Equation 3 may be obtained by organizing the Equation 2. From the Equation 3, the current $i\_in$ flowing in the first coil 321 and the current $i\_out$ flowing in the second coil may be obtained by adjusting $Z\_in$.

Wireless charging devices using wireless power transmission and reception may generate a magnetic field based on a current flowing in a coil. The processor 120 may adjust a shape of a magnetic field formed around the first coil 321 or the second coil 322 by controlling a current ratio $i\_out : i\_in$ flowing in the first coil 321 or the second coil 322 via the variable capacitor 410.

For example, when the impedance Zin of the loop including the first coil 321 is increased via the variable capacitor 410, the current $i\_out$ flowing in the second coil 322 may increase and the current $i\_in$ flowing in the first coil 321 may be reduced. According to the change of the current, a magnetic field may be stronger in a portion (e.g., an outer perimeter of an antenna) where the second coil 322 is positioned, and a magnetic field may be weaker in a portion (e.g., the inside of the antenna) where the first coil 321 is positioned. When the impedance Zin of the loop including the first coil 321 is reduced via the variable capacitor 410, the current $i\_out$ flowing in the second coil 322 may be reduced and the current $i\_in$ flowing in the first coil 321 may increase. According to the change of the current, the magnetic field may be weaker in the portion where the second coil 322 is positioned, and the magnetic field may be stronger in the portion where the first coil 321 is positioned. Since electromagnetic interaction with the external electronic device occurs strongly in a region where the magnetic field is strong, the electronic device 300 may improve efficiency of wireless charging when the magnetic field is strongly formed in a region where the external electronic device is disposed.

【Equation 4】

$$\frac{V_s}{i_{out}} = \frac{Z_{in}}{j\omega M}\left\{\frac{Z_{in}Z_{out}}{j\omega M} - j\omega M\right\}$$

When the Equation 2 is further organized, the Equation 4 may be obtained. When looking at the Equation 4, the voltage V_s applied to both ends of the control circuitry 420 is divided by the current i_out flowing in the second coil 322, which indicates input impedance. A value of impedance connected to both ends of the control circuitry 420 may be controlled by the impedance Z_in. The first coil 321 and the second coil 322 may be utilized as magnetic secure transmission (MST) or near field communication (NFC) as well as a wireless charging coil through a control of the impedance Z_in.

Referring to FIG. 5B, the first coil 321 may be connected to the set 510 of the capacitors. The second coil 322 may be connected to control circuitry and may be connected to the variable capacitor 410.

According to an embodiment, by adjusting the capacitance of the variable capacitor 410 connected to the second coil 322, a ratio of the current flowing in the first coil 321 and the second coil 322 may be adjusted.

Referring to FIGS. 5A and 5B, the variable capacitor 410 may be connected to one coil of the first coil 321 and the second coil 322, and the control circuitry 420 may be connected to the remaining one coil of the first coil 321 and the second coil 322. In case that the variable capacitor 410 and the control circuitry 420 are connected to different coils, the electronic device may control the ratio of the current flowing in the first coil 321 and the current flowing in the second coil 322.

According to the above-described embodiment, the electronic device 300 may adjust the ratio of the current flowing in the first coil 321, which is an inner coil of the coil module 320, and the second coil 322, which is an outer coil of the coil module 320, based on a position of the external electronic device or alignment of the external electronic device with respect to the coil module 320. Through the adjustment of the ratio of the current, the electronic device 300 may improve wireless charging efficiency. The electronic device 300 may use the coil module 320 as a wireless charging antenna and may use the coil module 320 as an antenna module for the MST or the NFC by adjusting the impedance value connected to both ends of the control circuitry 420. The electronic device 300 may increase spatial efficiency of the electronic device 300 by providing an antenna module that performs various functions via one coil module 320.

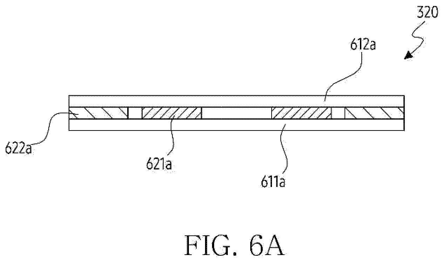

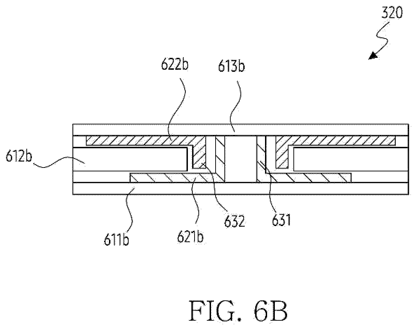

FIGS. 6A and 6B are cross-sectional views of an exemplary antenna including a first coil and a second coil of an electronic device according to an embodiment.

Referring to FIG. 6A, a coil module 320 may include a first coil 621a, a second coil 622a, a first non-conductive layer 611a, and a second non-conductive layer 612a. The coil module 320 may be a flexible printed circuit board including conductive parts (e.g., the first coil 621a and the second coil 622a) disposed in non-conductive layers.

According to an embodiment, the first non-conductive layer 611a and the second non-conductive layer 612a may be coverlay forming an exterior of the coil module 320. For example, the first non-conductive layer 611a and the second non-conductive layer 612a may surround the first coil 621a and the second coil 622a. For example, the first non-conductive layer 611a may support the first coil 621a and the second coil 622a. For example, the first coil 621a and the second coil 622a may be disposed on the first non-conductive layer 611a. The first coil 621a may be disposed on a surface of the first non-conductive layer 611a. The second coil 622a may be spaced apart from the first coil 621a on the surface of the first non-conductive layer 611a. The second coil 622a may be disposed along a periphery of the first coil 621a. The second coil 622a may be disposed to surround an exterior of the first coil 621a. According to an embodiment, the first coil 621a and the second coil 622a may be formed as substantially one plane. The first coil 621a and the second coil 622a may be covered by the second non-conductive layer 612a. The second non-conductive layer 612a may be disposed on the first coil 621a and the second coil 622a. A non-conductive material may be filled between the first coil 621a and the second coil 622a. A non-conductive material different from the first non-conductive layer 611a and the second non-conductive layer 612a may be disposed between the first coil 621a and the second coil 622a. For another example, a part of the first non-conductive layer 611a and the second non-conductive layer 612a may be disposed between the first coil 621a and the second coil 622a.

The first coil 621a and the second coil 622a may be magnetically coupled to each other. For example, when a current is supplied to the second coil 622a, the first coil 621a may interact with a magnetic field formed by the current flowing in the second coil 622a, and an induced current may be generated in the first coil 621a according to the interaction.

Referring to FIG. 6B, the coil module 320 may include a first coil 621b, a second coil 622b, a first non-conductive layer 611b, a second non-conductive layer 612b, and a third non-conductive layer 613b. The coil module 320 may be a flexible printed circuit board.

According to an embodiment, the first non-conductive layer 611b and the third non-conductive layer 613b may be coverlay forming the exterior of the coil module 320. For example, the first non-conductive layer 611b and the third non-conductive layer 613b may surround the first coil 621b and the second coil 622b. For example, the first non-conductive layer 611b may support the first coil 621b. For example, the first coil 621b may be disposed on the first non-conductive layer 611b. The first coil 621b may be disposed on a surface of the first non-conductive layer 611b.

According to an embodiment, the second non-conductive layer 612b may be disposed on the first coil 621b disposed on the first non-conductive layer 611b. The second non-conductive layer 612b may surround a surface of the first coil 621b disposed on the first non-conductive layer 611b. The second non-conductive layer 612b may include via holes, and the coil module 320 may include a first conductive via 631 connected to the first coil 621b via a part of the via holes.

According to an embodiment, the second coil 622b may be disposed on the second non-conductive layer 612b. The second non-conductive layer 612b may be disposed between the first coil 621b and the second coil 622b. The second non-conductive layer 612b may space the first coil 621b and the second coil 622b apart from each other. The coil module 320 may include a second conductive via 632 connected to the second coil 622b via a remaining part of the via holes. The first coil 621b and the second coil 622b may be physically spaced apart from each other and magnetically connected to each other. For example, the first coil 621b and the second coil may be spaced apart from each other. The first conductive via 631 connected to the first coil 621b may be spaced apart from the second conductive via connected to the second coil 622b. The first coil 621b and the second coil 622b may be magnetically coupled to each other. For example, when a current is supplied to the second coil 622b, the first coil 621b may interact with a magnetic field formed by the current flowing in the second coil 622b, and an induced current may be generated in the first coil 621b according to the interaction.

According to an embodiment, when the coil module 320 is viewed from above, the first coil 621b may overlap with a portion of the second coil 622b. At least one of an outer diameter and an inner diameter of the first coil 621b and the second coil 622b may have a different value. For example, even when an inner diameter of the first coil 621b is the same as an inner diameter of the second coil 622b, an outer diameter of the first coil 621b and an outer diameter of the second coil 622b may be different from each other. For example, even when the outer diameter of the first coil 621b is the same as the outer diameter of the second coil 622b, the inner diameter of the first coil 621b and the inner diameter of the second coil 622b may be different from each other. When the first coil 621b and the second coil 622b are completely overlapped, even when a current flowing in the first coil 621b and the second coil 622b is adjusted, it may be difficult to adjust an amount of a current according to an alignment state of an external electronic device. In case that the first coil 621b partially overlaps with the second coil 622b, when an amount of the current flowing in the first coil 621b increases, an amount of a current inside the coil module 320 may increase, and when an amount of the current flowing in the second coil 622b increases, an amount of a current flowing outside the coil module 320 may increase. In case that the first coil 621b partially overlaps with the second coil 622b, the amount of the current may be adjusted according to the alignment state of the external electronic device, which may increase charging efficiency.

According to the above-described embodiment, the coil module 320 may space the first coil 621a or 621b and the second coil 622a or 622b apart from each other and may magnetically couple the first coil 621a or 621b and the second coil 622a or 622b. The coil module 320 may increase charging efficiency of the external electronic device by adjusting a ratio of the current flowing in each of the first coil 621a or 621b and the second coil 622a or 622b.

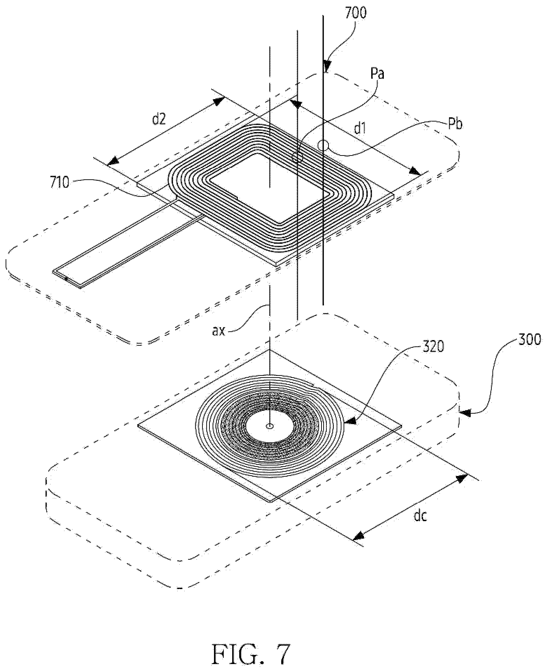

FIG. 7 is a diagram exemplarily illustrating a disposition of an electronic device and a wireless charger, according to an embodiment.

Referring to FIG. 7, an electronic device 300 may be arranged in a wireless charger 700, which is an external electronic device.

According to an embodiment, the electronic device 300 may include a coil module 320. The coil module 320 may be aligned with a charging coil 710 of the wireless charger 700. For example, the charging coil 710 may be larger than the coil module 320. For example, a length d1 of a long periphery of the charging coil 710 may be greater than an outer diameter dc of the coil module 320.

According to an embodiment, the electronic device 300 may change a capacitance value of a variable capacitor (e.g., the variable capacitor 410 of FIG. 4) connected to a second coil (e.g., the second coil 322 of FIG. 4) in order to improve charging efficiency at positions Pa and Pb spaced apart from a center of the charging coil 710 of the wireless charger 700.

In order to compare a performance of the electronic device 300 according to an embodiment, a comparative embodiment 1 may be configured to connect a first coil and the second coil in parallel, and a comparative embodiment 2 may be configured to selectively connect the first coil and the second coil.

The length d1 of the long periphery of the charging coil 710 may be approximately 49.7 mm, and a length d2 of a short periphery may be approximately 41.7 mm. The outer diameter dc of the coil module 320 may be approximately 42 mm.

The table below indicates charging efficiency in a first state in which the charging coil 710 and the coil module 320 are aligned, a second state in which a central axis of the coil module 320 is disposed at a position Pa that is misaligned by 5 mm from a central axis ax of the charging coil 710, and a third state in which the central axis of the coil module 320 is disposed at a position Pb that is misaligned by 10 mm from the central axis ax of the charging coil 710. According to an embodiment, the electronic device 300 may adjust capacitance of the variable capacitor to 60nF in the first state and the capacitance of the variable capacitor to 66nF in the third state.

[Table 1]

| | Embodiment | Comparative embodiment 1 | Comparative embodiment 2 | |
|---|---|---|---|---|
| | | | First coil connection | Second coil connection |
| First state | 89.8% | 88.4% | 78.3% | 89.3% |
| Second state | 88.9% | 89.1% | 81.2% | 88.1% |
| Third state | 85.3% | 85.4% | 75.2% | 83.9% |

According to an embodiment, the electronic device 300 may have higher charging efficiency in the first state compared to the comparative embodiments. In the second state and the third state, the electronic device 300 may have substantially the same performance as in case that only the second coil is connected among the comparative embodiment 1 and the comparative embodiment 2.

According to an embodiment, in a case of the wireless charger 700, since wireless charging is performed from the charging coil 710 with a large area, there may not be a significant difference in wireless charging efficiency between an unaligned case and an aligned case. For example, even when the charging coil 710 and the coil module 320 are not aligned, since a change in an overlapping area is small, wireless charging efficiency may be similar.

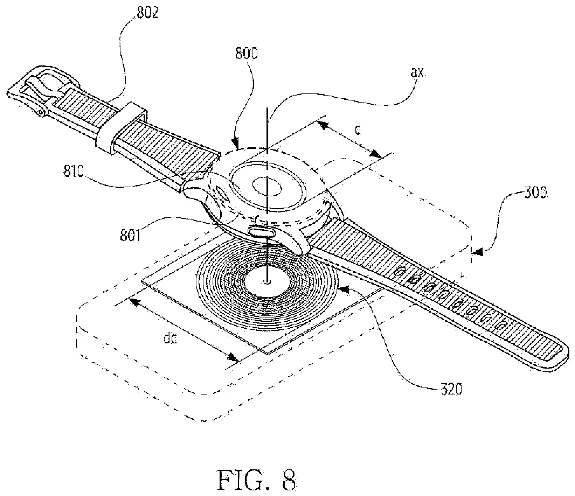

In a case of receiving power from the wireless charger 700, the electronic device 300 according to the above-described embodiment may maintain the highest performance among comparative examples. In case that the electronic device 300 shares power with an external electronic device (e.g., a wearable device) including a charging coil smaller than the coil module 320 of the electronic device 300, charging efficiency will be described with reference to FIG. 8.

FIG. 8 is a diagram exemplarily illustrating a disposition of an electronic device and a watch, according to an embodiment.

Referring to FIG. 8, an electronic device 300 may be arranged in a wearable device 800, which is an external electronic device.

According to an embodiment, the electronic device 300 may include a coil module 320. The coil module 320 may be aligned with a charging coil 810 of the wearable device 800. For example, the charging coil 810 may be smaller than the coil module 320. For example, a diameter d of the charging coil 810 may be smaller than an outer diameter dc of the coil module 320.

According to an embodiment, the wearable device 800 may include a main body 801 and a coupling member 802. The main body 801 may provide a space in which the charging coil 810 is to be mounted. The coupling member 802 may be wound on a part of a body of a user. The wearable device 800 may be worn on a part of the body of the user via the coupling member 802. The wearable device 800 may be referred to as a smart watch or a smart band in terms of being worn on an arm that is a part of the body of the user. The electronic device 300 may supply power to the wearable device 800. For example, the electronic device 300 may transmit a part of power of a battery to the wearable device 800.

According to an embodiment, the electronic device 300 may change a capacitance value of a variable capacitor (e.g., the variable capacitor 410 of FIG. 4) connected to a second coil (e.g., the second coil 322 of FIG. 4) to improve charging efficiency at positions pc spaced apart from a center of the charging coil 810 of the wearable device 800.

In order to compare a performance of the electronic device 300 according to an embodiment, a comparative embodiment 1 may be configured to connect a first coil and the second coil in parallel, and a comparative embodiment 2 may be configured to selectively connect the first coil and the second coil.

The diameter of the charging coil 810 may be approximately 24.5 mm. The outer diameter dc of the coil module 320 may be approximately 42 mm.

The table below indicates charging efficiency in a first state in which the charging coil 810 and the coil module 320 are aligned and in a second state in which a central axis ax of the charging coil 810 and a central axis ax of the coil module 320 are misaligned by 5 mm. According to an embodiment, the electronic device 300 may adjust capacitance of the variable capacitor to 120 nF in the first state and the capacitance of the variable capacitor to 150 nF in the second state.

[Table 2]

| | Embodiment | Comparative embodiment 1 | Comparative embodiment 2 | |
|---|---|---|---|---|
| | | | First coil connection | Second coil connection |
| First state | 84.1% | 74.1% | 83.6% | 58.1% |
| Second state | 80.4% | 77.0% | 78.6% | 67.7% |

According to an embodiment, the electronic device 300 may have higher charging efficiency in the first state and in the second state compared to the comparative embodiments.

When compared to the wireless charging device 800 of FIG. 7, in a case of the wearable device 800, since power is supplied by the charging coil 810 with a narrow area, there may be a relatively large difference in wireless charging efficiency between an unaligned case and an aligned case. For example, in case that the charging coil 810 and the coil module 320 are not aligned, a change in an overlapping area between the charging coil 810 and the first coil or the second coil is large, so wireless charging efficiency may have a big difference.

Since the electronic device 800 may increase an amount of a current in a region where the wearable device is positioned by adjusting a current flowing in the first coil 321 and the second coil 322 of the coil module 320, high charging efficiency may be maintained even in misalignment of the wearable device.

According to the above-described embodiment, when the first coil 321, the second coil 322, and the charging coil 810 are concentric based on the alignment distance, the processor 120 may be configured to change the capacitance value of the variable capacitor 410 to increase an induced current of the first coil 321.

According to an embodiment, the electronic device 100 may adjust a current ratio of the current flowing in the first coil 321 and the second coil 322 by adjusting the capacitance of the variable capacitor 410. For example, in case that the external electronic device is disposed close to the first coil 321, the electronic device may adjust the capacitance of the variable capacitor 410 to increase an amount of the current flowing in the first coil 321.

When identifying that a separation distance (e.g., an alignment distance) between the central axis ax and the external electronic device increases, the processor 120 according to an embodiment may be configured to change the capacitance value of the variable capacitor 410 to increase the current of the second coil 322 disposed at an outer perimeter.

According to the above-described embodiment, the electronic device 100 may adjust the current ratio of the current flowing in the first coil 321 and the second coil 322 by adjusting the capacitance of the variable capacitor 410. For example, in case that the external electronic device is disposed closer to the second coil 322 than the first coil 321, the electronic device 300 may increase an amount of the current flowing in the second coil 322 by adjusting the capacitance of the variable capacitor 410.

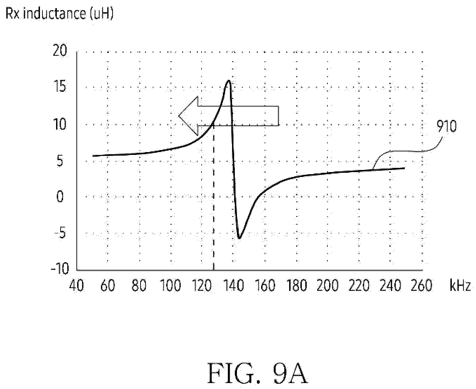

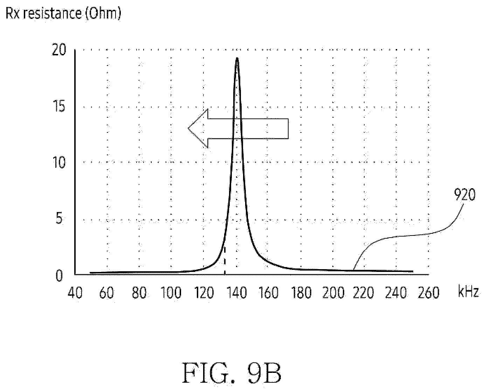

FIGS. 9A and 9B illustrate inductance and a resistance value of a coil according to capacitance of a capacitor according to an embodiment.

Referring to FIGS. 9A and 9B, a graph 910 of FIG. 9A indicates inductance of input impedance according to a frequency, and a graph 920 of FIG. 9B indicates a resistance value of input impedance according to a frequency. An x-axis of the graph 910 may indicate a frequency, and a unit may be kHz. The graph 910 may indicate inductance among components of the input impedance, and a unit may be $\mu$H. An x-axis of the graph 920 may indicate a frequency, and a unit may be kHz. The graph 920 may indicate a resistance value, which is a real number, among the component of the input impedance, and a unit may be $\Omega$. The graph 910 and the graph 920 may determine the inductance and the resistance value based on the Equation 4. According to the Equation 4, as capacitance of a variable capacitor increases, a frequency may be reduced. Inductance corresponding to 130 kHz may be 11.4 $\mu$H from the graph 910, and a resistance value may be 1.8 $\Omega$ from the graph 920. The electronic device 300 may operate in an MST mode by adjusting a capacitance value of the variable capacitor.

According to the above-described embodiment, the electronic device 300 may use a coil module 320 as a wireless charging antenna and may use the coil module 320 as an antenna module for MST or NFC by adjusting an impedance value connected to both ends of control circuitry 420. The electronic device 300 may increase spatial efficiency of the electronic device 300 by providing an antenna module that performs various functions via one coil module 320.

According to the above-described embodiment, an electronic device (e.g., the electronic device 300 of FIG. 3) may comprise a battery (e.g., the battery 189 of FIG. 3) and a first coil (e.g., the first coil 321 of FIG. 3) disposed on the battery. The electronic device may further comprise a second coil (e.g., the second coil 322 of FIG. 3). The second coil may be magnetically coupled to the first coil and wound along a periphery of the first coil. The electronic device may further comprise a variable capacitor (e.g., the variable capacitor 410 of FIG. 4). The variable capacitor may be connected to both ends of the first coil. The electronic device may further comprise control circuitry (e.g., the control circuitry 420 of FIG. 4). The control circuitry may be connected to both ends of the second coil. The control circuitry may supply a current to the second coil to generate an induced current to the first coil. The control circuitry may be configured to supply power from an external electronic device to the battery or transmit power from the battery to the external electronic device based on the current and the induced current. The electronic device may further comprise a sensor (e.g., the sensor 340 of FIG. 3). The sensor may be configured to identify a position of the external electronic device with respect to the first coil or the second coil. The electronic device may further comprise a processor (e.g., the processor 120 of FIG. 1). According to an embodiment, the processor may be configured to identify the position of the external electronic device with respect to the first coil and the second coil via the sensor. The processor may be configured to change a capacitance value of the variable capacitor based on the identified position of the external electronic device.

According to the above-described embodiment, the processor or a coil module may control an amount of a current flowing in the first coil or the second coil via the variable capacitor. By controlling the amount of the current flowing in the first coil or the second coil, the electronic device may increase wireless charging efficiency with the external electronic device.

According to an embodiment, when the battery is viewed from above, a center of the first coil may be the same as a center of the second coil.

According to an embodiment, the first coil and the second coil may be disposed on the battery.

The first coil and the second coil according to the above-described embodiment may be electrically connected to the battery, so that the first coil and the second coil may transmit power to the battery. The battery may supply power to the outside of the electronic device, by supplying power to the first coil and the second coil.

According to an embodiment, the electronic device may further comprise a first non-conductive layer (e.g., the first non-conductive layer 611a of FIG. 6A). The first non-conductive layer 611a may be disposed on the battery and may support the first coil and the second coil. According to an embodiment, a lateral surface of the first coil and a lateral surface of the second coil may face each other. According to an embodiment, the first coil may be substantially the same plate.

According to the above-described embodiment, the electronic device may reduce a thickness of the coil module including the first coil and the second coil by disposing the first coil and the second coil on the same plane, thereby increasing mounting efficiency inside the electronic device.

According to an embodiment, the electronic device may further comprise a first non-conductive layer (e.g., the first non-conductive layer 611b of FIG. 6B) disposed on the battery and supporting the first coil, and a second non-conductive layer (e.g., the second non-conductive layer 612b of FIG. 6B) disposed between the first coil and the second coil.

According to the above-described embodiment, the electronic device may dispose to overlap the first coil and a part of the second coil by disposing the second non-conductive layer between the first coil and the second coil.

According to an embodiment, the second coil may be electrically connected to the battery via the control circuitry and may be configured to transmit power to the battery or receive power from the battery.

According to the above-described embodiment, the electronic device may differently adjust an amount of the current flowing in the first coil and the second coil by connecting one coil (e.g., the second coil) of the first coil and the second coil to the control circuitry.

According to an embodiment, the electronic device may further comprise a printed circuit board (e.g., the first printed circuit board 311 of FIG. 3) on which the control circuitry and the processor are disposed.

According to an embodiment, the second coil may be electrically connected to the printed circuit board.

According to an embodiment, the processor may obtain a sensing value via the sensor. The processor may identify an alignment distance from a center of the first coil and the second coil to a center of a third coil in the external electronic device, based on the sensing value.

According to an embodiment, the processor may be configured to control magnitude of the induced current of the first coil and magnitude of the current of the second coil, via the variable capacitor based on the alignment distance.

According to the above-described embodiment, the electronic device may adjust the current flowing in the first coil and the second coil by identifying whether the external electronic device is aligned. Through the adjustment of the current, the electronic device may adjust wireless charging efficiency with the external electronic device.

According to an embodiment, the processor may be configured to change the capacitance value of the variable capacitor to increase the induced current of the first coil, when identifying that the first coil, the second coil, and the third coil are concentric based on the alignment distance.

According to the above-described embodiment, the electronic device may adjust a current ratio of the current flowing in the first coil and the second coil by adjusting the capacitance of the variable capacitor. For example, in case that the external electronic device is disposed close to the first coil, the electronic device may change an amount of the current flowing in the first coil by adjusting the capacitance of the variable capacitor.

According to an embodiment, the processor may be configured to change the capacitance value of the variable capacitor to change the current of the second coil, when identifying that the alignment distance is increased.

According to the above-described embodiment, the electronic device may adjust the current ratio of the current flowing in the first coil and the second coil by adjusting the capacitance of the variable capacitor. For example, in case that the external electronic device is disposed closer to the second coil than the first coil, the electronic device may increase an amount of the current flowing in the second coil by adjusting the capacitance of the variable capacitor.

According to an embodiment, the electronic device may further comprise a first temperature sensor and a second temperature sensor.

According to an embodiment, the processor may be configured to identify, based on sensing values of the first temperature sensor and the second temperature sensor, a position of the external electronic device.

Through a difference between temperature values of the first temperature sensor and the second temperature sensor according to the above-described embodiment, the electronic device may obtain a distance that the external electronic device is spaced apart from the center of the first coil and the second coil. Based on the obtained distance, the electronic device may adjust the amount of the current of the first coil and the second coil.

According to an embodiment, the electronic device may further comprise a housing forming an exterior of the electronic device.

According to an embodiment, the first temperature sensor may be disposed between a first lateral surface of the housing and the second coil.

According to an embodiment, the second temperature sensor may be disposed between a second lateral surface of the housing opposite to the first lateral surface and the second coil.

According to the above-described embodiment, by disposing the first sensor and the second sensor between the first coil and a lateral surface and between the second coil and a lateral surface, the electronic device may identify whether the external electronic device is aligned from a center of a coil.

According to an embodiment, the first temperature sensor may be disposed at an outer perimeter of the second coil.

According to an embodiment, the second temperature sensor may be surrounded by the first coil and the second coil.

According to an embodiment, the sensor may be disposed between the first coil and the second coil.

According to the above-described embodiment, the electronic device may increase efficiency of a mounting space for electronic components in the electronic device by disposing one of the temperature sensors in an empty space between the coils.

According to an embodiment, the electronic device may further comprise a non-conductive plate forming a surface of the electronic device.

According to an embodiment, the first coil and the second coil may be disposed between the non-conductive plate and the battery.

According to the above-described embodiment, the non-conductive plate may be disposed to overlap with the first coil and the second coil. The first coil and the second coil disposed to overlap may transmit power to or receive power from the external electronic device via the non-conductive plate.

According to an embodiment, when the battery is viewed from above, the second coil may partially overlap with a portion including a periphery of the first coil.

According to the above-described embodiment, an area of the first coil and the second coil may be increased by disposing the first coil and the second coil to overlap each other. Through the increased area, the first coil may increase a total amount of the current flowing via the second coil.

According to an embodiment, the first coil and the second coil may receive power from the external electronic device including a wireless charging coil configured to interact with the first coil and the second coil, and transmit the received power to the battery via the control circuitry.

According to an embodiment, the first coil and the second coil may be configured to transmit power from the battery including the wireless charging coil configured to interact with the first coil and the second coil to the external electronic device.

According to the above-described embodiment, an electronic device (e.g., the electronic device 300 of FIG. 3) may comprise a battery (e.g., the battery 189 of FIG. 3), a first coil (e.g., the first coil 321 of FIG. 3) disposed on the battery, a second coil (e.g., the second coil 322 of FIG. 3), magnetically coupled with the first coil, wound along a periphery of the first coil, control circuitry (e.g., the control circuitry 520 of FIG. 4), connected with the first coil, configured to, supply a current to the first coil to generate an induced current in the second coil, and based on the current and the induced current, supply power from an external electronic device to the battery or transmit power from the battery to the external electronic device, a variable capacitor (e.g., the variable capacitor 410 of FIG. 4) connected with the second coil, a sensor (the sensor 340 of FIG. 3) configured to identify a position of the external electronic device with respect to the first coil or the second coil, and a processor (e.g., the processor 120 of FIG. 1). The processor may be configured to identify, via the sensor, the position of the external electronic device with respect to the first coil and the second coil, and based on the identified position of the external electronic device, change a capacitance value of the variable capacitor.

According to the above-described embodiment, the processor or a coil module may control an amount of a current flowing in the first coil or the second coil via the variable capacitor. By controlling the amount of the current flowing in the first coil or the second coil, the electronic device may increase wireless charging efficiency with the external electronic device.

According to an embodiment, the variable capacitor may be connected to one coil of the first coil and the second coil. The control circuitry may be connected to another one coil of the first coil and the second coil.

According to an embodiment, when the battery is viewed from above, the first coil may be concentric with the second coil. The battery may overlap with the first coil and the second coil.

According to an embodiment, the second coil may be electrically connected to the battery via the control circuitry and may be configured to transmit power to the battery or receive power from the battery.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

**1.** An electronic device (100; 300) comprising:

a battery (189);
a first coil (321) disposed on the battery (189);
a second coil (322), magnetically coupled with the first coil (321), wound along a periphery of the first coil (321);
a variable capacitor (410) connected with the first coil (321);
control circuitry (420), connected with the second c oil (322), configured to:

supply a current to the second coil (322) to generate an induced current in the first coil (321), and based on the current and the induced current, supply power from an external electronic device to the battery (189) or transmit power from the battery (189) to the external electronic device;

a sensor (340) configured to identify a position of the external electronic device with respect to the first coil (321) or the second coil (322); and
a processor (120),
wherein the processor (120) is configured to:

identify, via the sensor (340), the position of the external electronic device with respect to the first coil (321) or the second coil (322), and
based on the identified position of the external electronic device, change a capacitance value of the variable capacitor (410).

2. The electronic device (100; 300) of claim 1,
wherein, when the battery (189) is viewed from above:

the first coil (321) is concentric with the second coil (322), and
the battery (189) overlaps with the first coil (321) and the second coil (322).

3. The electronic device (100; 300) of any one of claims 1 to 2, further comprising a first non-conductive layer (611a), disposed on the battery (189), supporting the first coil (321) and the second coil (322),
wherein the first coil (321) and the second coil (322) are disposed on a substantially same plane and are spaced apart from each other.

4. The electronic device (100; 300) of any one of claims 1 to 3, further comprising:

a first non-conductive layer (611b), disposed on the battery (189), supporting the first coil (321); and
a second non-conductive layer (612b) disposed between the first coil (321) and the second coil (322).

5. The electronic device (100; 300) of any one of claims 1 to 4,
wherein the second coil (322) is electrically connected to the battery (189) via the control circuitry (420) and is configured to transmit power to the battery (189) or receive the power from the battery (189).

6. The electronic device (100; 300) of any one of claims 1 to 5, further comprising a printed circuit board (PCB) (311) on which the control circuitry (420) and the processor (120) are disposed,
wherein the second coil (322) is electrically connected to the PCB (311).

7. The electronic device (100; 300) of any one of claims 1 to 6,
wherein the processor (120) is configured to:

obtain a sensing value via the sensor (340),
based on the sensing value, identify an alignment distance from a center of the first coil (321) and the second coil (322) to a center of a third coil (710; 810) in the external electronic device, and
control magnitude of the induced current of the first coil (321) and magnitude of the current of the second coil (322), via the variable capacitor (410) based on the alignment distance.

8. The electronic device (100; 300) of any one of claims 1 to 7,
wherein the processor (120) is configured to change the capacitance value of the variable capacitor (410) to change the induced current of the first coil (321), when identifying that the first coil (321), the second coil (322), and the third coil (710; 810) are concentric based on the alignment distance.

9. The electronic device (100; 300) of any one of claims 1 to 8,
wherein the processor (120) is configured to change the capacitance value of the variable capacitor (410) to change the current of the second coil (322), when identifying that the alignment distance is increased.

10. The electronic device (100; 300) of any one of claims 1 to 9,

wherein the sensor (340) includes a first temperature sensor (340) and a second temperature sensor (340), and wherein the processor (120) is configured to identify, based on sensing values of the first temperature sensor (340) and the second temperature sensor (340), a position of the external electronic device.

11. The electronic device (100; 300) of any one of claims 1 to 10, further comprising a housing (310) forming an exterior of the electronic device (100; 300),

wherein the first temperature sensor (340) is disposed between a first lateral surface of the housing (310) and the second coil (322), and
wherein the second temperature sensor (340) is disposed between a second lateral surface of the housing (310) opposite to the first lateral surface and the second coil (322).

12. The electronic device (100; 300) of any one of claims 1 to 11,

wherein the first temperature sensor (340) is disposed at an outer perimeter of the second coil (322), and
wherein the second temperature sensor (340) is surrounded by the first coil (321) and the second coil (322).

13. The electronic device (100; 300) of any one of claims 1 to 12,
wherein the sensor (340) is disposed between the first coil (321) and the second coil (322).

14. The electronic device (100; 300) of any one of claims 1 to 13, further comprising a non-conductive plate forming a surface of the electronic device (100; 300),
wherein the first coil (321) and the second coil (322) are disposed between the non-conductive plate and the battery (189).

15. The electronic device (100; 300) of any one of claims 1 to 14,
wherein, when the battery (189) is viewed from above, the second coil (322) partially overlaps with a portion including a periphery of the first coil (321).

FIG. 1

200

197

WIRELESS COMMUNICATION
MODULE 192

MST COMMUNICATION
MODULE 210

NFC COMMUNICATION
MODULE 230

POWER MANAGEMENT
MODULE 188

WIRELESS CHARGING
MODULE 250

297-1

297-3

297-5

FIG. 2

FIG. 3

FIG. 4

FIG. 5A

FIG. 5B

FIG. 6A

320

622b    613b

612b

632    631

611b    621b

FIG. 6B

EP 4 583 366 A1

FIG. 7

27

FIG. 8

FIG. 9A

Rx resistance (Ohm)

FIG. 9B

# EP 4 583 366 A1

## INTERNATIONAL SEARCH REPORT

International application No.

**PCT/KR2023/014319**

### A. CLASSIFICATION OF SUBJECT MATTER

**H02J 50/90**(2016.01)i; **H02J 50/12**(2016.01)i; **H02J 50/00**(2016.01)i; **H01Q 1/38**(2006.01)i; **H01Q 7/06**(2006.01)i; **H01Q 1/24**(2006.01)i; **G01K 1/02**(2006.01)i; **H01F 27/40**(2006.01)i

According to International Patent Classification (IPC) or to both national classification and IPC

### B. FIELDS SEARCHED

Minimum documentation searched (classification system followed by classification symbols)

H02J 50/90(2016.01); H02J 17/00(2006.01); H02J 50/12(2016.01); H02J 50/70(2016.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 무선 전력(wireless power), 코일(coil), 위치(location), 커패시터(capacitor)

### C. DOCUMENTS CONSIDERED TO BE RELEVANT

| Category* | Citation of document, with indication, where appropriate, of the relevant passages | Relevant to claim No. |
|---|---|---|
| Y | KR 10-2018-0034744 A (INDUSTRY-ACADEMIC COOPERATION FOUNDATION, YONSEI UNIVERSITY) 05 April 2018 (2018-04-05)<br>See paragraphs [0036]-[0058], claims 1-6, and figures 1-11. | 1-3 |
| Y | KR 10-2017-0108218 A (SAMSUNG ELECTRONICS CO., LTD.) 27 September 2017 (2017-09-27)<br>See paragraphs [0043]-[0068], and figures 5-8. | 1-3 |
| A | US 2019-0190324 A1 (APPLE INC.) 20 June 2019 (2019-06-20)<br>See paragraphs [0140]-[0158], and figures 4A-4D. | 1-3 |
| A | KR 10-2018-0076359 A (KOREA ADVANCED INSTITUTE OF SCIENCE AND TECHNOLOGY et al.) 05 July 2018 (2018-07-05)<br>See entire document. | 1-3 |
| A | KR 10-2013-0041870 A (LG INNOTEK CO., LTD.) 25 April 2013 (2013-04-25)<br>See entire document. | 1-3 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **10 January 2024** | **10 January 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

31

**INTERNATIONAL SEARCH REPORT**

International application No.

**PCT/KR2023/014319**

| | |
|---|---|
| **Box No. II** | **Observations where certain claims were found unsearchable (Continuation of item 2 of first sheet)** |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☑ Claims Nos.: **4-15**
because they are dependent claims and are not drafted in accordance with the second and third sentences of Rule 6.4(a).

Form PCT/ISA/210 (continuation of first sheet) (July 2022)

**INTERNATIONAL SEARCH REPORT**
Information on patent family members

International application No.

**PCT/KR2023/014319**

| Patent document cited in search report | | | Publication date (day/month/year) | Patent family member(s) | | | Publication date (day/month/year) |
|---|---|---|---|---|---|---|---|
| KR | 10-2018-0034744 | A | 05 April 2018 | EP | 3300211 | A1 | 28 March 2018 |
| | | | | EP | 3300211 | B1 | 14 December 2022 |
| | | | | KR | 10-1846715 | B1 | 10 April 2018 |
| | | | | US | 11218033 | B2 | 04 January 2022 |
| | | | | US | 2018-0091005 | A1 | 29 March 2018 |
| | | | | WO | 2018-056529 | A1 | 29 March 2018 |
| KR | 10-2017-0108218 | A | 27 September 2017 | KR | 10-2499362 | B1 | 13 February 2023 |
| | | | | US | 10326307 | B2 | 18 June 2019 |
| | | | | US | 2017-0271920 | A1 | 21 September 2017 |
| US | 2019-0190324 | A1 | 20 June 2019 | CN | 109792166 | A | 21 May 2019 |
| | | | | CN | 109792166 | B | 05 August 2022 |
| | | | | CN | 115208079 | A | 18 October 2022 |
| | | | | KR | 10-2019-0032533 | A | 27 March 2019 |
| | | | | KR | 10-2021-0064424 | A | 02 June 2021 |
| | | | | KR | 10-2258835 | B1 | 01 June 2021 |
| | | | | KR | 10-2391835 | B1 | 27 April 2022 |
| | | | | US | 11159065 | B2 | 26 October 2021 |
| | | | | US | 2021-0359556 | A1 | 18 November 2021 |
| | | | | WO | 2018-057656 | A1 | 29 March 2018 |
| KR | 10-2018-0076359 | A | 05 July 2018 | KR | 10-1932228 | B1 | 20 March 2019 |
| KR | 10-2013-0041870 | A | 25 April 2013 | KR | 10-2013-0007173 | A | 18 January 2013 |
| | | | | KR | 10-2013-0123349 | A | 12 November 2013 |
| | | | | WO | 2013-002488 | A1 | 03 January 2013 |

Form PCT/ISA/210 (patent family annex) (July 2022)